# EUROPEAN PATENT APPLICATION

(11) **EP 4 814 775 A1**
(43) Date of publication of application: **30.09.2026**
(21) Application number: 25166439.7
(22) Date of filing: 26.03.2025
(51) Int. Cl.: G06F 30/20, G06Q 50/40

(54) **METHODS AND SYSTEMS FOR AUTOMATICALLY DETERMINING OPTIMUM ELECTRIC VEHICLE CHARGING STATION LOCATIONS**

(71) Applicant: FUJITSU LIMITED, Kawasaki-shi, Kanagawa 211-8588 (JP)
(72) Inventor: OLMEZ, Sedar, Slough, SL1 2BE (GB)
(74) Representative: Haseltine Lake Kempner LLP

(57) **Abstract**

A computer-implemented method of automatically determining optimum electric vehicle (EV) charging station real-world locations, based on a simulation of a particular real-world target area, comprising: receiving real-world EV data, comprising data for a plurality of target EVs associated with the target area, and for each target EV comprising at least one start location and associated start time, at least one finish location and associated finish time, and a distance between the start location and finish location; determining charging demand locations in the target area, being locations in which the target EVs need to charge, comprising performing a simulation of the routes taken by the target EVs based on the EV data, and plotting the charging demand locations onto a map of the target area; retrieving population density data for the target area and plotting the population density data onto the map of the target area; clustering, based on the map of the target area, the charging demand locations to determine candidate EV charging station locations; and determining optimum EV charging station locations, comprising weighting the candidate EV charging station locations based on the population density data, and plotting the optimum EV charging station locations onto the map of the target area.

## Description

### Field of the Invention

The present invention relates to methods and systems for automatically determining where to locate electric vehicle (EV) charging stations, and in particular doing so based on real-world usage and demand data.

### Background of the Invention

The increased uptake in EVs leads to a continuously and rapidly changing demand for more charging stations and charging stations in different locations. Further, the EV charging infrastructure that does exists is sporadic and outdated, and was built using locations convenient to build on or with existing fuelling infrastructure such as at petrol stations, but was not built on the present on the actual demand of real users. The current charging infrastructure cannot cope with increasing demand, leading to longer waiting times, increased downtime, and inefficiencies, for instance for EV fleet operators such as delivery companies.

Hence there is a need for improved methods and systems of determining EV charging station locations, for instance based on real-world user demand, thereby making EV charging more efficient, faster and more convenient.

Certain aspects of the present disclosure and their embodiments may provide solutions to these or other challenges.

### Statement of the Invention

Aspects of the invention are defined by the accompanying claims. Advantageous optional features are defined in the dependent claims.

According to an aspect there is provided a computer-implemented method of automatically determining optimum electric vehicle (EV) charging station real-world locations, based on a simulation of a particular real-world target area, comprising:
receiving real-world EV data, comprising data for a plurality of target EVs associated with the target area, and for each target EV comprising at least one start location and associated start time, at least one finish location and associated finish time, and a distance between the start location and finish location;
determining charging demand locations in the target area, being locations in which the target EVs need to charge, comprising performing a simulation of the routes taken by the target EVs based on the EV data, and plotting the charging demand locations onto a map of the target area;
retrieving population density data for the target area and plotting the population density data onto the map of the target area;
clustering, based on the map of the target area, the charging demand locations to determine candidate EV charging station locations; and
determining optimum EV charging station locations, comprising weighting the candidate EV charging station locations based on the population density data, and plotting the optimum EV charging station locations onto the map of the target area.

Various aspects and embodiments of the invention are described without limitation below, with reference to the figures.

### Brief Description of the Drawings

There now follows, by way of example only, a detailed description of preferred embodiments of the present invention, with reference to the figures identified below.
**Figure 1** illustrates a method;
**Figure 2** illustrates a diagram;
**Figure 3** illustrates a diagram;
**Figure 4** illustrates a diagram;
**Figure 5** illustrates a diagram;
**Figure 6** illustrates a diagram;
**Figure 7** illustrates an apparatus.

### Detailed Description

In the following description, functionally similar parts carry the same reference numerals between figures. The following sets forth specific details, such as particular aspects, embodiments or examples for purposes of explanation and not limitation. It will be appreciated by one skilled in the art that other examples may be employed apart from these specific details. Aspects and embodiments of the invention are now described, without limitation and by way of example only, with reference to the accompanying drawings.

Aspects and embodiments may advantageously provide improved methods and systems of determining EV charging station locations, for instance based on real-world user demand, thereby making EV charging infrastructure and EV charging itself more widely used, more efficient, faster and more convenient.

Aspects and embodiments may advantageously provide a real-world data driven approach to determine the best locations for EV charging stations given the actual real-world user demand and real-world usage of the existing EV charging infrastructure, for instance advantageously determining problems and inefficiencies and sub-optimal arrangements in existing infrastructure.

Aspects and embodiments may advantageously provide methods of analysing where vehicles actually need to charge and in combination with where people actually live, and identify strategically useful new charging station locations to reduce the time and distance vehicles travel to charge, and weight the size of the stations according to the population such that charging needs are accurately accounted for.

Aspects and embodiments may advantageously allow for improved EV charging infrastructure reducing overall charging time and trip distance for vehicles, and increasing utilization rates and overall efficiency, for instance for a fleet operator with particular pre-defined routes and vehicles performing services such as delivery.

Aspects and embodiments may advantageously provide, through the use of real-world simulation based on real-world data, reduced wastage in materials in locating EV charging stations in sub-optimal locations, which may then need to be relocated or which are not used sufficiently to justify their continued operation.

Aspects and embodiments may advantageously provide a method of determiningwhere EV charging stations should be located based on both where people actually live, and also where the charging demand given existing trips actually occurs. Accordingly, aspects and embodiments may advantageously provide improved accuracy methods for determining where there currently exists a real-world demand for EV charging, based on current users and their existing trips and usage patterns in real-world data.

Aspects and embodiments may advantageously provide advanced data analytics and empirical data in the EV charging structure determination which allow for accurately reflecting real-world demand and usage patterns.

Aspects and embodiments may advantageously provide for identifying optimal locations for new charging stations is a less time-consuming manner and using up-to-date information and data.

Aspects and embodiments may advantageously provide account for the dynamic nature of urban environments and existing EV usage patterns.

Aspects and embodiments may advantageously be able to accurately and appropriately weight the number of charging slots for a particular identified EV charging station by the target population density and demand, thereby reducing either underutilized or overcrowded charging stations, which can for instance discourage EV adoption due to inconvenience and longer waiting times for users.

Aspects and embodiments may advantageously provide automated and data-driven approaches which significantly reduce the time required to determine the best sites for new charging station infrastructure, allowing for quicker and more effective deployment of charging stations.

Aspects and embodiments may advantageously provide for integrating empirical data and advanced simulation techniques, thereby ensuring the planning of charging stations is based on accurate and detailed information, leading to more effective and efficient infrastructure deployment.

Aspects of the invention are defined by the accompanying claims. Advantageous optional features are defined in the dependent claims.

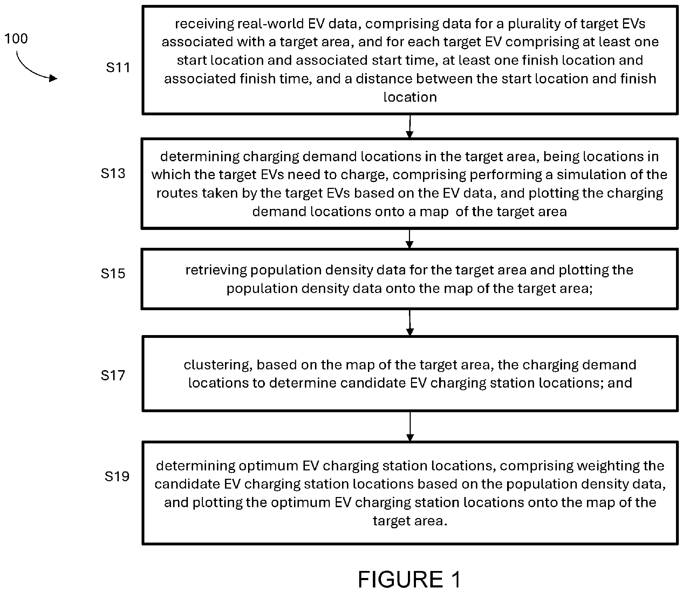

**Figure 1** is a diagram illustrating a method 100 according to an aspect. In particular, the process may be computer-implemented method of automatically determining optimum electric vehicle (EV) charging station real-world locations, based on a simulation of a particular real-world target area.

Step S11 comprises receiving real-world EV data, comprising data for a plurality of target EVs associated with the target area, and for each target EV comprising at least one start location and associated start time, at least one finish location and associated finish time, and a distance between the start location and finish location.

Step S13 comprises determining charging demand locations in the target area, being locations in which the target EVs need to charge, comprising performing a simulation of the routes taken by the target EVs based on the EV data, and plotting the charging demand locations onto a map of the target area.

Step S15 comprises retrieving population density data for the target area and plotting the population density data onto the map of the target area.

Step S17 comprises clustering, based on the map of the target area, the charging demand locations to determine candidate EV charging station locations.

Step S19 comprises determining optimum EV charging station locations, comprising weighting the candidate EV charging station locations based on the population density at each candidate EV charging station location, and plotting the optimum EV charging station locations onto the map of the target area.

Advantageously, aspects and embodiments in accordance with method 100 are able to provide an improved methods and systems of determining EV charging station locations, for instance based on real-world user demand, thereby making EV charging infrastructure and EV charging itself more widely used, more efficient, faster and more convenient.

In a specific embodiment, the EV data may further comprise, for each target EV, at least one of EV model, powertrain information, battery capacity, and range data. The real-world EV data may be pre-processed using trip segmentation functionality.

In a specific embodiment, the EV data may comprise the routes taken by the target EVs, or wherein the routes taken by the target EVs are determined based on the EV data.

In a specific embodiment, the simulation may comprise an agent-based model configured to simulate the trips the target EVs took along their routes, based on the EV data, wherein the locations in which the target EVs needed to charge in the simulation are determined to be the charging demand locations. The simulation may be the Autofleet model simulation.

In a specific embodiment, the plotting of the charging demand locations onto a map of the target area may comprise plotting a heatmap of the charging demand locations. The heatmap may be derived using Kepler.gl

In a specific embodiment, the weighting may comprises: the higher the population density at a particular candidate EV charging station location, the higher the weighting, and wherein the optimum EV charging station locations are selected from the candidate EV charging station locations which have relatively higher weightings. The optimum EV charging station locations may be selected as the four candidate EV charging station locations with the highest weightings.

In a specific embodiment, the clustering may comprises determining a number of clusters of the charging demand locations, each cluster comprising a plurality of charging demand locations, and further comprising determining the centroid of each cluster.

In a specific embodiment, determining optimum EV charging station locations may comprises weighting the candidate EV charging station locations based on the population density within a fixed radius of the centroid. The weighting may further comprises normalising the population density at each candidate EV charging station location to determine the average population density within the radius. The radius may be chosen based on the population density. The radius may be for instance 5km

In a specific embodiment, determining optimum EV charging station locations may comprises, for each centroid: determining, for each charging demand location, the distance from the charging demand location to the centroid; selecting a subset of the charging demand locations which are within the radius as the candidate EV charging station locations; weighting and ranking the candidate EV charging station locations based on the population density at each candidate EV charging station location; and selecting, from the candidate EV charging station locations, the optimum EV charging station locations as the plurality of candidate EV charging station locations with the highest ranking.

The number of the plurality of candidate EV charging station locations may be user defined, and optionally four top rankings.

The determining the optimum EV charging location may further be based on a weighting comprising distance to an existing EV charging station location.

In a specific embodiment, determining the number of slots at each optimum EV charging station location may be based on a relationship between the number of slots determined and the population density at the optimum EV charging station location. the relationship may be a linear relationship,

In a specific embodiment, the clustering may be performed using a machine learning model. The clustering may comprise k-means clustering using an unsupervised machine learning model, optionally further comprising using the elbow method to determine the number of clusters for use in the k-means clustering. The number of clusters may be six.

In a specific embodiment, the real-world EV data may be collected from sensors, such as GPS sensors, within each EV.

In a specific embodiment, the determined optimum EV charging station locations may be used in a subsequent method to install real-world EV charging station locations at the determined optimum EV charging station locations.

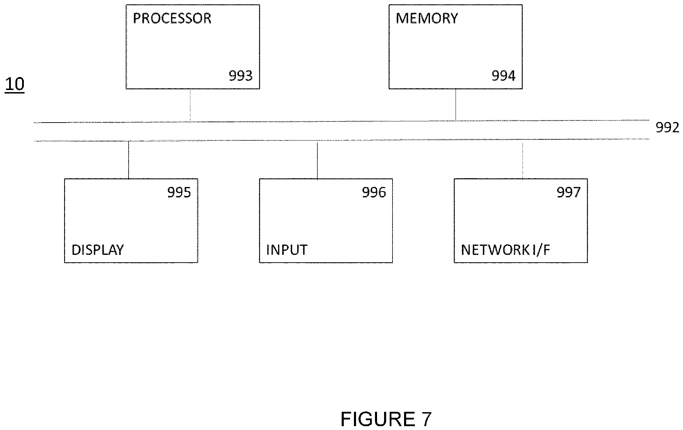

Any of the steps of **Figure 1** may be performed by an apparatus as described with reference to **Figure 7****.**

In accordance with any aspect or embodiment herein, the target area may be any area of relevance, and for instance may be a city such as Cape Town, Delhi or Mumbai. Any locations described herein such as real-world locations may be latitude and longitude data corresponding to particular geographical locations on Earth.

In particular, in a specific embodiment of step S11, the real-world EV data comprises data taken from real-world measurements of the movements of EVs, where the wording 'target EV' is used to refer to an EV of interest in the real world, for instance an EV which is a user in the specific target area of interest. As an example, the real-world EV data may come from publicly available information, or may come from a private company such as a fleet operator, for instance of a delivery company. However, the specific nature of the data is not limiting. Regardless of source of origin, the dataset is retrieved and input into the method.

In particular, in a specific embodiment of step S11, the EV data may further comprise, for each target EV, at least one of EV model, powertrain information, battery capacity, and range data.

In a further specific embodiment of step S11, the EV data may comprise the routes taken by the target EVs.

In a specific embodiment, data from a target area - such as a city, such as Delhi - may be retrieved which includes the following information:
- Vehicle model - such as the vehicle model in a particular fleet;
- Powertrain information - such as the type of engine;
- Range - such as the maximum range the EV can do on a single charge;
- The minimum charge % at which an EV travels to a charging station - such as the % of charge at which an EV looks for a charging station (i.e. 25%);
- Battery capacity - such as the capacity of the EV battery;
- Start location - such as the pickup location latitude and longitude for start of trips;
- Finish location - such as the drop-off location latitude and longitude for the end of the trips;
- Route - the route taken between start location and finish location.

In further specific embodiments of step S11, the real-world EV data may further comprises, for instance:
- Location of charging stations - such as the latitude and longitude of refuel stations known to the EV or the system as a whole
- Fill rate for charging stations - such as, the kW capacity of the amount of energy that can be drawn from the station;
- Slots and Parking slots of the charging station - such as the number of charging slots and parking slots at the charging station.

In a specific embodiment of step S11, the real-world EV data may first need to be pre-processed. For instance, this may depend on the format of the real-world EV data.

In a specific embodiment of step S11, the real-world EV data is pre-processed using trip segmentation, for instance using Python's data science stack as would be understood by the skilled person. In particular, in embodiments in which the real-world EV data does not comprise route data, but only includes start location and finish location, it may be necessary to perform pre-processing to determine potential routes taken by target EVs in the real-world data, for instance from which and using which aspects and embodiments as described herein may determine locations where EV charging stations are desired or required.

For instance, trip segmentation tools may provide routes for particular target EVs based on the EV data given only the start location, the finish location, the time taken and the distance between the start location and finish location.

In any aspect and embodiment as described herein, the real-world EV data may be taken from physical sensors in the target EVvehicles, or from physical sensors in the target area environment. For instance, the EV data may come from at least GPS within the target EVs and/or cameras in the target area environment. Other appropriate sensors could also be used. In specific embodiments, the EV data could be live or recent data being collected in real time, and/or the EV data could include historic data collected over longer periods of time.

In a specific embodiment of step S13, the routes of each target EV are simulated, the routes being either in the EV data or derived therefrom in any manner as previously described. In particular, based on the EV data, a simulation is performed for all of the target EVs which is capable of simulating their individual journeys and determining for each locations in which each target EV would need to charge, or it would be preferable for it to charge, referred to as charging demand locations. The determination of the charging demand locations may be performed in the simulation, for instance based on simulating the route of the target EV given the EV data. For instance, when the EV data comprises includes range and/or battery capacity and/or the minimum charge % at which an EV travels to a charging station, this data can be used in combination within the simulation to determine charging demand locations. Alternatively, other criteria could be used in addition to the EV data, such as for instance an arbitrary or user defined condition such that target EVs will be assumed to look for or require a charging station after a fixed period of time or fixed period of travel. Regardless of specific manner of determination within the simulation, the simulation allows for/provides the determination and identification of locations (i.e. latitude and longitudes) at which the target EV vehicles needed to charge

Any appropriate simulation may be used. For instance, any simulation capable of simulating complex systems may be used, for instance agent-based models. In a specific example, an off-the-shelf simulation may be used such as Autofleet (https://autofleet.io).

In a specific embodiment of step S13, the simulation comprises an agent-based model configured to simulate the trips the target EVs took along their routes, based on the EV data, wherein the locations in which the target EVs needed to charge in the simulation are determined to be the charging demand locations.

Regardless of the specific form of the simulation, the output may include several key performance indicators (KPIs), and in particular may include the charging demand locations for each EV, for instance in the format of latitude and longitude.

There may be a plurality of charging demand locations determined for each target EV.

Having determined the charging demand locations, the charging demand locations for all target EVs in the target area can then be plotted onto a map of the target area.

In a specific embodiment of step S13, the charging demand locations so determined may be plotted onto to the map of the target area in the form of a heatmap. For instance, the heatmap may display the latitude and longitude of each charging demand location, and the contrast may be weighted to show the relative number of charging demand locations at a particular location. Any suitable heatmap may be used, for instance heatmaps as provided by Kepler.gl (https://kepler.gl/).

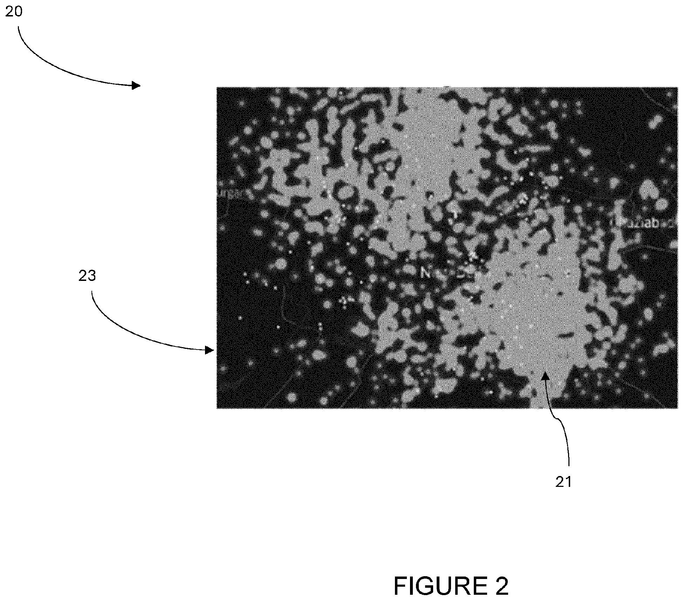

**Figure 2** shows an example visualization of a heatmap created in accordance with methods as described herein, wherein the target city is Delhi. As shown there, the lighter contrast 21 is locations where charging demand locations were determined to be, the darker contrast 23 is locations where no charging demand locations were determined to be, and the intensity of the light areas correlates to an increased number of charging demand locations in the area.

In any aspect as described herein, the map 20 of the target area may be a visual map 20, for instance stored as data and displayed on a screen when accessed, or may simply be a data structure comprising latitude and longitude information. Further, the map 20 may take any suitable form, and may for instance be a Folium map 20 created using Python script.

In a specific embodiment of step S15, the population density data may be open-source data from publicly available databases, for instance census data. For instance, using the specific example of Delhi, it may be possible to retrieve open source data on the Indian population and then process this to identify and filter the information for Delhi specifically when Delhi is the target area.

In a specific embodiment of step S15, plotting the population density data onto the map 20 of the target area may comprise overlaying the population density information on top of the charging demand locations previously plotted onto the map 20.

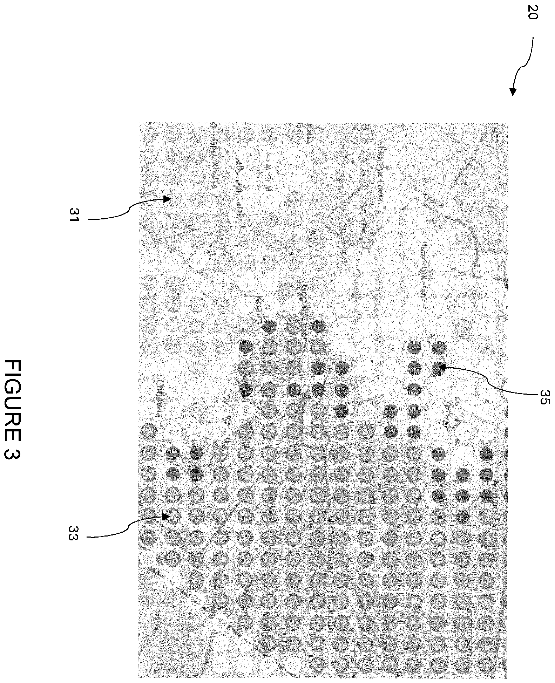

The specific visualization of the population density data may take any appropriate form. For instance, **Figure 3** represents an example visualization of the population density represented as a lattice of circles with increasing opacities from low population density, for instance from low density 31, to medium density 33, to high density 35. Note that for visual clarity **Figure 3** does not show the charging demand data on the same map 20.

In accordance with step S17, the input to this stage may be the combined data of the previous stages S13 and S15, and in particular the combined data relating to the charging demand locations and the population density, specifically in the form of the map 20 data as described in any previous manner. However, the clustering requires only the charging demand locations to have been identified and is primarily based on this.

In a specific embodiment of step S17, the clustering may be performed using a machine learning model, such as an unsupervised machine learning model. Further, the clustering may comprises any suitable clustering method, such as for instance k-means clustering.

In a further specific embodiment of step S17, the elbow method may advantageously be used to first determine the optimal number of k clusters. In specific embodiments in accordance with the method as described herein, the optimal number of clusters was determined to be six.

Once the clustering process is completed, this advantageously allows the identification of clusters of candidate EV charging locations. The candidate EV charging station locations are either a subset of the charging demand locations, or are determined based on statistical analysis of the charging demand locations.

For instance, in a specific embodiment, for each cluster, it is possible to determine the centroid - i.e. the mean of all charging demand locations in the cluster, or in other words the point which is the shortest distance to each of the charging demand locations within that cluster. In certain embodiments, the centroid may be considered a good location for an EV charging station and may be defined as a candidate EV charging station location.

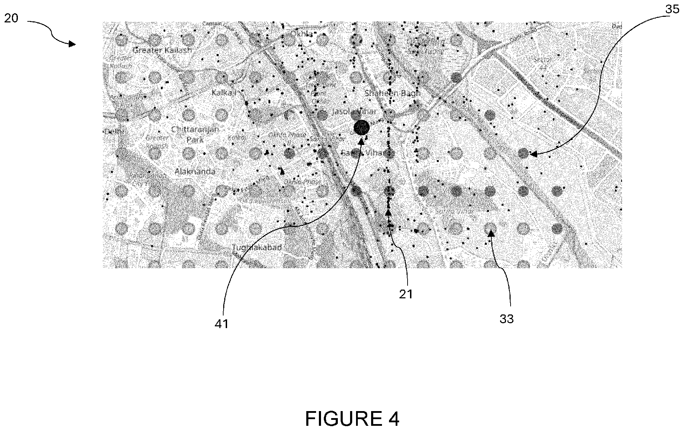

**Figure 4** shows an example representation of the map 20 of the target area including the population density data (33, 35), the charging demand locations plotted as points 21, and the centroid 41.

Hence the clustering stage in accordance with any manner of step S15 as described herein advantageously provides the first stage of determining the optimum EV charging station locations, as it does this based on all the individual charging demand locations determined for each target EV. In other words, the clustering stage may be considered to advantageously group high-demand real-world charging demand locations.

Hence advantageously, methods in accordance with step S17 may be capable of providing a targeted approach to determining EV charging locations, through the use of clustering, which allows for reduced unnecessary infrastructure in low-demand areas and optimizes the allocation of resources to high-demand regions.

Hence, following the clustering step S17 as described in any manner herein, the method then proceeds to perform what may be referred to as a second stage - in step S19 - of determining the optimum EV charging station locations, based on the clustering and population density data.

In aspects and embodiments, it may be said that the charging demand locations are combined with the population density data to allow for prioritization and weighting of charging demand locations by high-demand area and/or where most people live. Thereby advantageously allowing for better EV charging station provisioning.

In a specific embodiment of step S19, the weighting comprises: the higher the population density at a particular candidate EV charging station location, the higher the weighting, and wherein the optimum EV charging station locations are selected from the candidate EV charging station locations which have relatively higher weightings.

Hence in a specific embodiment the optimum EV charging station locations may be selected by weighting and ranking the candidate EV charging station locations. For instance, in a specific embodiment when the centroids 41 are determined, the centroids 41 may be weighted and may be ranked or processed in an appropriate manner to determine which are to be the final optimum EV charging station locations.

Hence in certain embodiments the optimum EV charging station locations are a subset of the centroids 41.

In a specific embodiment, the weighting of the centroid 41 may be performed based on the population density within a fixed radius of the centroid 41. For instance the fixed radius may be user defined, and can take any appropriate value, for instance 5km for a city such as Delhi. However, the size of the radius may be chosen based on the population density data, for instance to be smaller in high population density areas and larger in low population density areas.

In a specific embodiment, the weighing of the centroids 41 may be defined using the following pseudocode algorithm for each centroid 41:

```
      // Weighting centroids
      FOR each row in selected_points:
          // Calculate the density factor using population density, scale down by 1e6,
          limit max value to 10
          density_factor = MIN(row['avg_population_density'] / 1e6, 10)
```

where:
- selected_points = each of the charging demand locations within the user-defined fixed radius of the centroid;
- density_factor = density factor for centroid in question
- avg_population_density = average population density within the fixed radius as determined using the population density data.

Hence it can be seen that the weighting of the centroids 41 is performed based on weighing the centroids 41 using a normalizing scale of one million (1e6), thereby capturing the average population density within the 5km radius. This weighting of the centroids 41 may be used later as input to, for instance, determining the number of charging slots to be included at any particular determined optimum EV charging station locaiton.

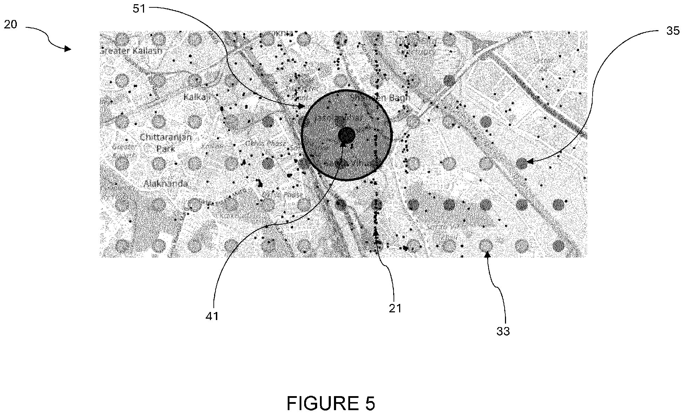

Further, in certain embodiments, it may be desirable to provide a visualization of the weighting of the centroids 41. An example is demonstrated in **Figure 5****,** which is the view of **Figure 4** but with the additional weighting of the centroid visualized 51. The visualization ('CircleMaker') of the centroid 41 may be represented using the following pseudocode algorithm for each centroid:

```
      // Create a CircleMarker at the centroid location with adjusted radius based on
      population density
          CREATE CircleMarker with parameters:
             - location = [row['centroid_latitude'], row['centroid_longitude']]
             - radius = 10 + (density_factor * 5) // Base radius is 10, adjust based on
             density
             - color = 'black' // Color for the outline of the circle
             - fill = TRUE // Enable filling the circle
             - fill_color = 'black' // Color for filling the circle
             - fill_opacity = 0.4 // Set the opacity to allow map details to be visible
             through the circle
```

where:
- centroid_latitude = the centroid latitude, for instance on the map
- centroid_longitdue = the centroid longitude, for instance on the map

Hence as can be seen this algorithm draws a circle around the centroid 41 based on the population density as previously defined.

Regardless of the specific manner of determination of the centroid 41, the centroids 41 are also plotted on the map 20 of the target area.

In a specific embodiment of step S19, in embodiments in which a centroid 41 is determined, determining the optimum EV charging station locations comprises weighting the candidate EV charging station locations based on the population density within a fixed radius of the centroid 41.

In particular, the fixed radius is the same as the previously defined fixed radius as used when performing weighting of the centroid 41. Here, a method may be performed in which, within the fixed radius, a determination of the charging demand locations therein and the population density at or around each charging demand location may be used to weight and rank the candidate charging locations and to determine the candidate EV charging station locations.

In particular, in a specific embodiment, determining the optimum EV charging station locations comprises, for each centroid: determining, for each charging demand location, the distance from the charging demand location to the centroid; selecting a subset of the charging demand locations which are within the radius as the candidate EV charging station locations; weighting and ranking the candidate EV charging station locations based on the population density at each candidate EV charging station location; and selecting, from the candidate EV charging station locations, the optimum EV charging station locations as the plurality of candidate EV charging station locations with the highest ranking.

In particular, in accordance with this specific embodiment, a method is provided in which, for each cluster, the original charging demand locations are filtered by being within a pre-determined fixed radius of the centroid to determined candidate (i.e. possible or potential) optimum EV charging station locations, and these are then weighted and ranked by the population density data,where only the highest ranking locations are chosen to be the optimum EV charging station locations where the system determines that an EV charging station location should advantageously be located to best and most efficiently suit the current demand.

In particular, a pseudocode algorithm representing a process in accordance with the method may be defined as below. The algorithm creates an empty data frame with latitude, longitude of the charging demand locations of the cluster, and the respective centroid. The distance from each point to the centroid is calculated and added to a column called distance_to_centroid. These points are then filtered depending on population density ranking and whether they are within the pre-determined fixed radius, set as 5km below in the following pseudocode. Finally, based on the weightings and rankings, the highest ranking are selected, wherein the number of the highest ranking may be predetermined and user defined. In the below pseudocode the number chosen is four, such that the top four locations are chosen. The pseudocode is the following:

```
      // Initialise an empty list or structure to store candidate charging locations with
      specified attributes
      Initialise charging_locs with columns 'latitude', 'longitude', 'centroid'
      // Iterate over each centroid
      For each centroid:
          Extract centroid_latitude as centroid_lat
          Extract centroid_longitude as centroid_lon
          // For each charging demand location in the associated cluster, calculate the
          distance to the current centroid
          For each charging demand location in the cluster:
             Calculate distance from centroid (centroid_lat, centroid_lon) to charging
             demand location (Latitude, Longitude)
             Store this distance in a new column 'distance_to_centroid' for the point
          // Filter out points that are within a predefined radius of the centroid
          // and sort these points by population density, selecting the top 4
          Filter points where 'distance_to_centroid' <= radius_km
          Sort filtered points by 'Population_Density' in descending order
          Select the top 4 points from the sorted list as optimum EV charging station
          locations
          
```

where:
- population_density = the population density at the charging demand location

Hence it can be seen from this that the optimum EV charging station locations can be determined. The step of filtering by radius can be done at any point in the demonstrated method, for instance either at the beginning or the end.

Hence, advantageously, the optimum EV charging station locations determined in this manner - for instance four per cluster - have been determined taking into account real world charging demand location data, and population density in the areas of interest, such that the optimum EV charging station locations are selected to be simultaneously in areas where there is a high demand as based on the charging demand locations, and a high population such that the maximum possible population can benefit from and use the optimum EV charging station locations. These optimum EV charging station locations can then be plotted on the map 20 of the target area.

Further, in a specific embodiment, a further factor may be taken into consideration comprising determining the existing location of real-world EV charging station locations, and wherein when the determined optimum EV charging station locations are too close to an existing EV charging station location, either selecting a new optimum EV charging station location, for instance from the top ranked location outside the top four as previously described. Alternatively, in accordance with the method described above, a weighting based on the distance from the optimum EV charging station location to an existing EV charging station location may also be included in the weighting with proximity to an existing EV charging station location resulting in a lower ranking. Hence, in accordance with specific embodiments, determining the optimum EV charging location is further based on a weighting comprising distance to an existing EV charging station location. The locations of existing EV charging stations may be taken from open-source information.

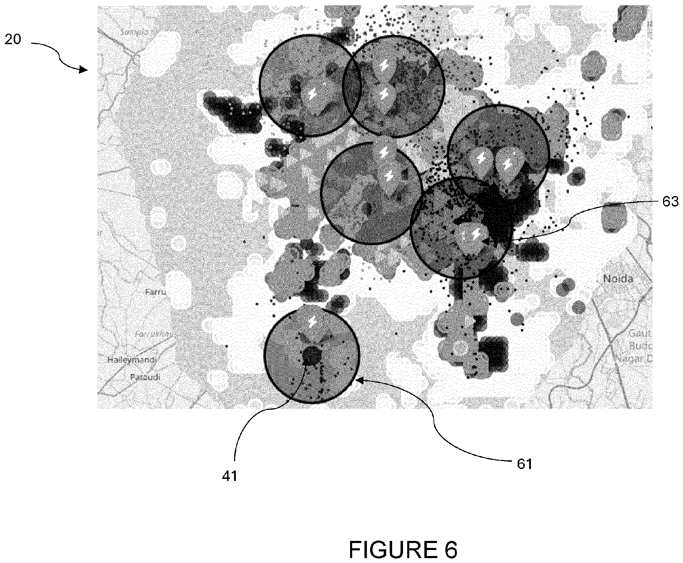

**Figure 6** is an example representation of the final map 20 showing the determined EV charging station locations in accordance with any manner as described herein, wherein the optimum EV charging station locations 63 are shown for each cluster, wherein the example map 20 is shown as having an example six clusters and six centroids, each having the predetermined fixed radius, for instance of 5km as previously defined.

In a further specific embodiment, advantageously the number of charging slots to be allocated to each optimum EV charging station location is also determined. The determination of the number of slots may be based on the previously determined population density, such as population_density in the above pseudocode, at each optimum EV charging station location, and may for instance be further based on the weighted centroid process as previously described with reference to **Figure 5****.** Hence advantageously the number of slots can be increased to meet the increased demand based on increased population in each area, or reduced to save costs in areas with relatively lower populations.

In particular, the relationship between the number of slots and the population density. For instance, the relationship may be a linear interpolation relationship. For instance, in a specific embodiment the relationship for defining the assigned slots may be defined as follows, for each optimum EV charging station location: $Assigned slots = min slots + \left(max slots-min slots\right) \frac{population density}{maximum population density}$ where:
- min_slots = the minimum number of a predetermined user specified range of possible number of slots, such as 2
- max_slots = the maximum number of a predetermined user specified range of possible number of slots, such as 12.
- population density = the population density at the optimum EV charging station location
- maximum population density = maximum population density in target area

Accordingly, as can be seen, the last term normalizes the population density of the optimum EV charging station location to a value between 0 and 1. This is done by dividing the population density of the current location by the maximum density found in the target area. Hence a location with the maximum observed density would have a normalized value of 1, and a location with zero density would have a normalized value of 0. The normalized value is then scaled to the range defined by the minimum and maximum slot values, which are pre-defined user variables. The expression (max slots - min slots) calculates the total range of slots available. Multiplying this range by the normalized density scales this range according to how dense the population is at the optimum EV charging station location. Finally, adding the minimum number of slots min slots offsets the scaled value so that the minimum value starts at min slots rather than 0. This ensures that even the least population dense location (after scaling) is assigned the minimum number of slots instead of none.

As an example, if the minimum slots is set as 2 and the maximum slots 12, and a particular optimum EV charging station location's density is exactly half of the maximum density in the target area, the calculation would proceed as follows:
- The normalization step would yield 0.5 (since the density is half of the maximum).
- The scaling step takes the range of slots (12-2=10) and scales it by 0.5, resulting in 5.
- Adding the offset (2) to this scaled value results in 7 slots being assigned to this location.

Accordingly, aspects and embodiments as described herein may advantageously allow for an efficient and fair distribution of slots at each determined optimum EV charging station location, whilst still allowing for a minimum slow allocation to less dense areas.

A pseudocode representation of the above may be provided as:

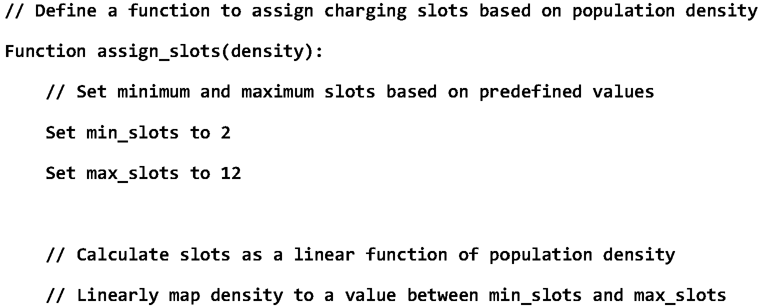

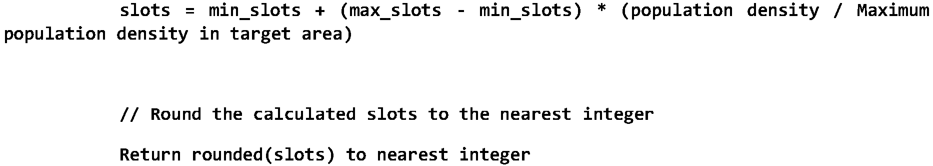

Hence, in accordance with any aspects or embodiments as described herein, the determined optimum EV charging station locations may be used in a subsequent method to install real-world EV charging station locations at the determined optimum EV charging station locations. In particular, real world EV charging stations may be built at the determined optimum EV charging station locations and hence real world EV charging infrastructure can be improved in line with any of the advantages as described herein, including creating more widely used, more efficient EV charging infrastructures. Further still, the example visualization as shown in **Figure 6** may be used to assist in this operation, where, as with any of the map visualizations described or shown herein, it is possible to zoom in and out on the map visualization when displayed on a digital computer screen.

Any of the aspects and embodiments described herein may be provided by specific dedicated software modules optimised and configured for their specific role, and which work in synergy in the methods as described above.

Having performed any method as described in accordance with aspects and embodiments herein, there is advantageously outputted a plurality of optimum EV charging station locations. These optimum EV charging station locations are determined to be those locations which are advantageously best placed to serve both the current existing demand (as based on the charging demand locations) and to serve the highest number of people (as determined by the population density data).

To demonstrate the advantageous outcomes and efficacy of the methods in accordance with any aspect as defined herein, it is possible to compare the 'Original Simulation' as previously described with reference to step S13 using the original target EVs data, which was performed on the existing EV charging station infrastructure in the real-world target area, against a simulation of the original target EVs data in the real-world target area as modified to include new charging stations installed at the optimum EV charging station locations as determined by methods as described herein, 'Simulation including opium EV charging station locations'. Comparing statistics from these two simulations would provide a proof of concept.

Accordingly, these two simulations were run using the previously mentioned Autofleet model, and the comparison was performed for target areas of Delhi and Mumbai, and key performance indicators (KPIs) of relevance were determined, as shown in Tables 1 and 2 below. The simulations were performed using fleet data provided by a delivery company, and the numbers are totals across the EVs of the entire fleet, where:
- Average Charging Time per Task (minutes) = The average time it takes to charge an electric vehicle.
- Average In-route Time to Charge per Task (minutes) = The average time it takes for vehicles to get to the nearest charging station.
- Average Waiting Time to Charge per Task (minutes) = The average time a vehicle has to wait to charge once it arrives at the charging station.
- Charging Time Utilization (%) = the proportion of time that charging infrastructure is actively used to charge electric vehicles (EVs) within a given period.
- Energy Utilization (%) = measures the efficiency of energy consumption within a fleet's operations. A higher Energy Utilization % indicates that a greater share of the fleet's energy consumption is dedicated to revenue-generating tasks, reflecting efficient operational practices. Conversely, a lower percentage suggests that a significant portion of energy is consumed without contributing directly to service delivery, highlighting areas where efficiency improvements may be needed.
- Number of Charging Tasks = The number of times vehicles used a charging facility throughout the simulation.
- Total Charging Time (minutes) = The total sum of the time vehicles have spent charging.
- Total In-route Time to Charge (minutes) = The total sum of the time it takes for vehicles to reach a charging station.
- Total Waiting Time to Charge (minutes) = The total sum of the time vehicles spent waiting for charge at a charging station.

**Table 1. The aggregated KPIs for Delhi**

| **Key performance indicator** | **Original simulation** | **Simulation including opium EV charging station locations** |
|---|---|---|
| Average Charging Time per Task (minutes) | 167.1948406203724 | 48.66947033416682 |
| Average In-route Time to Charge per Task (minutes) | 7.46933208635335 | 5.994998863378029 |
| Average Waiting Time to Charge per Task (minutes) | 0.05077546566908261 | 0.009737061453360585 |
| Charging Time Utilization (%) | 1.3875000184733577 | 0.274116928614925 |
| Energy Utilization (%) | 1.3875000184733566 | 0.27411692861492454 |
| Number of Charging Tasks | 4,277 | 4,399 |
| Total Charging Time (minutes) | 715,092.3333333331 | 214,097.00000000006 |
| Total In-route Time to Charge (minutes) | 31,946.333333333332 | 26,372 |
| Total Waiting Time to Charge (minutes) | 217.16666666666666 | 42.833333333333336 |

**Table 2. The aggregated KPIs for Mumbai**

| **Key performance indicator** | **Original simulation** | **Simulation including opium EV charging station locations** |
|---|---|---|
| Average Charging Time per Task (minutes) | 261.8856318010216 | 78.03283344694388 |
| Average In-route Time to Charge per Task (minutes) | 8.50144348212303 | 7.1450806634855715 |
| Average Waiting Time to Charge per Task (minutes) | 0.0579613590939374 | 0.00011361054305839614 |
| Charging Time Utilization (%) | 0.2764183310823601 | 0.06509509482622704 |
| Energy Utilization (%) | 0.27641833108235936 | 0.06509509482622712 |
| Number of Charging Tasks | 1,501 | 1,467 |
| Total Charging Time (minutes) | 393,090.3333333334 | 114,474.16666666667 |
| Total In-route Time to Charge (minutes) | 12,760.666666666666 | 10,481.833333333334 |
| Total Waiting Time to Charge (minutes) | 87 | 0.16666666666666666 |

As can be seen, there are significant improvements in the results from the 'Simulation including opium EV charging station locations'.

In particular, the implementation of new charging infrastructure including the determined optimum EV charging station locations - as defined in the 'Simulation including opium EV charging station locations' - has led to a substantial improvement in charging efficiency, with a 70.88% and 70.20% reduction in the average charging time for vehicles for Delhi and Mumbai respectively. This enhancement not only demonstrates the effectiveness of the optimum EV charging station locations but also significantly contributes to the convenience and usability of electric vehicles.

A slight drop in the average time vehicles needed to meet their targets factoring in their trip to the charging station was observed. Roughly a 19.67% and 15.88% drop for Delhi and Mumbai respectively. This trend demonstrates that the placement of the new charging locations have had a positive impact on the distance and time it takes vehicles to charge compared to the original scenario in the existing infrastructure.

The average waiting time to charge per charging event across all vehicles has also dropped albeit by a small amount, the original values are small at roughly two decimal places. This means that the fleet data used and trips simulated has led to vehicles not having to wait a long time on average during their trips. It is worth comparing the total time vehicles spent waiting to charge as another dimension to this statistic to gauge the improvements. In Delhi, the total time waiting to charge dropped by 80.27% and for Mumbai this was 99.81%. Given these results, the total amount of time vehicles needed to wait to charge has substantially dropped, this trend can further be improved by increasing the number of accessible chargers with a greater number of charging slots.

The charging time utilization indicator, demonstrates the percent of time spent fulfilling charging related activities. For Delhi a drop of 1.11% compared to Mumbai's 0.21%, it is clear that the general trend shows that vehicles are not having to spend as much time conducting charging related activities as new charging station location placements with higher fill rates in areas of high charging demand could boost productivity as time can be spent delivering more items or doing other fleet activities. The percentage of energy utilization is also similar to the aforementioned statistics, the amount of energy required also drops.

The number of charging tasks i.e. the number of times a vehicle has needed to visit a charger has interestingly increased in Delhi by 2.88% and decreased in Mumbai by 2.26%. One way to interpret this value could be that the number of deliveries and routes taken (sometimes drivers may not opt to use the shortest distance route to a destination due to traffic) can impact the number of times a vehicle needs to charge, furthermore, the capacity of the batteries also impacts this. We therefore cannot say with certainty that by increasing the number of charging station locations that vehicles would use these newly placed chargers less frequently.

The total charging time spent across all vehicles within the fleets for both Delhi and Mumbai has substantially dropped, with 70.06% and 70.87% drop for Delhi and Mumbai respectively. This means that the amount of time spent charging has substantially dropped. These values are based on the time the charging cable is plugged in and the time it is taken out.

A similar trend compared to the aforementioned statistic is the total amount of time a vehicle spent in-route to a charging station, this KPI corresponds to the placement of the new charging stations at the optimum EV charging station locations as determined in accordance with aspects and embodiments as described herein. We observe a drop of 17.44% and 17.86% for Delhi and Mumbai respectively. This means that by incorporating charging demand data from fleet operators and population density into the weighting of these demand clusters, we can advantageously better plan where new charging stations should be placed within cities. This could then impact the amount of time vehicles spent travelling to charging stations.

Accordingly, aspects and embodiments may advantageously provide for determining an EV charging infrastructure that allows for reduced charging time, shorter travel time to charge, lower waiting time, and better operational efficiency.

According to an aspect there is provided a computer program which, when run on a computer, causes the computer to carry out the method of automatically determining optimum electric vehicle (EV) charging station real-world locations, based on a simulation of a particular real-world target area in accordance with any manner as described herein.

According to an aspect there is provided an information processing apparatus comprising a memory and a processor connected to the memory, wherein the processor is configured to perform the method of automatically determining optimum electric vehicle (EV) charging station real-world locations, based on a simulation of a particular real-world target area in accordance with any manner as described herein.

### Example Computer System implementation

**Figure 7** is a block diagram of an information processing apparatus 10 or a computing device 10, such as a data storage server, which embodies the present invention, and which may be used to implement some or all of the operations of a method embodying the present invention, and perform some or all of the tasks of apparatus of an embodiment. The computing device 10 may be used to implement any of the method steps described above and/or any processes described above.

The computing device 10 comprises a processor 993 and memory 994. Optionally, the computing device also includes a network interface 997 for communication with other such computing devices. Optionally, the computing device also includes one or more input mechanisms such as keyboard and mouse 996, and a display unit such as one or more monitors 995. These elements may facilitate user interaction. The components are connectable to one another via a bus 992.

The memory 994 may include a computer readable medium, which term may refer to a single medium or multiple media (e.g., a centralized or distributed database and/or associated caches and servers) configured to carry computer-executable instructions. Computer-executable instructions may include, for example, instructions and data accessible by and causing a computer (e.g., one or more processors) to perform one or more functions or operations. For example, the computer-executable instructions may include those instructions for implementing a method disclosed herein, or any method steps disclosed herein, and/or any processes described above. Thus, the term "computer-readable storage medium" may also include any medium that is capable of storing, encoding or carrying a set of instructions for execution by the machine and that cause the machine to perform any one or more of the method steps of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing computer program code stored in the memory 994 to implement any of the method steps described herein. The memory 994 stores data being read and written by the processor 993 and may store training data and/or network weights and/or patches and/or updated patches and/or embeddings and/or vectors and/or graphs and/or representations and/or difference amounts and/or equations and/or other data, described above, and/or programs for executing any of the method steps and/or processes described above. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and operations discussed herein. The processor 993 may be considered to comprise any of the modules described above. Any operations described as being implemented by a module may be implemented as a method by a computer and e.g. by the processor 993.

Optionally, the apparatus 10 includes a display unit 995 which may display a representation of data stored by the computing device.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball etc. may be included in the computing device.

Methods embodying the present invention may be carried out on a computing device/apparatus 10 such as that illustrated in **Figure 7****.** Such a computing device need not have every component illustrated in **Figure 7****,** and may be composed of a subset of those components. For example, the apparatus 10 may comprise the processor 993 and the memory 994 connected to the processor 993. Or the apparatus 10 may comprise the processor 993, the memory 994 connected to the processor 993, and the display 995. A method embodying the present invention may be carried out by a single computing device in communication with one or more data storage servers via a network. The computing device may be a data storage itself storing at least a portion of the data.

The invention may be implemented in digital electronic circuitry, or in computer hardware, firmware, software, or in combinations of them. The invention may be implemented as a computer program or computer program product, i.e., a computer program tangibly embodied in a non-transitory information carrier, e.g., in a machine-readable storage device, or in a propagated signal, for execution by, or to control the operation of, one or more hardware modules.

A computer program may be in the form of a stand-alone program, a computer program portion or more than one computer program and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

For the purposes of the present disclosure, the term "machine learning model" encompasses within its scope the following concepts:
- machine Learning algorithms, comprising processes or instructions through which data may be used in a training process to generate a model artefact for performing a given task, or for representing a real world process or system;
- the model artefact that is created by such a training process, and which comprises the computational architecture that performs the task; and
- the process performed by the model artefact in order to complete the task.

References to "machine learning model", "model", model parameters", "model information", etc., may thus be understood as relating to any one or more of the above concepts encompassed within the scope of "Machine learning model".
The above-described embodiments of the present invention may advantageously be used independently of any other of the embodiments or in any feasible combination with one or more others of the embodiments.

### Alternative Embodiments

The embodiments described above are illustrative of, rather than limiting to, the present invention. Alternative embodiments apparent on reading the above description may nevertheless fall within the scope of the invention.

## Claims

1. A computer-implemented method of automatically determining optimum electric vehicle (EV) charging station real-world locations, based on a simulation of a particular real-world target area, comprising:
receiving real-world EV data, comprising data for a plurality of target EVs associated with the target area, and for each target EV comprising at least one start location and associated start time, at least one finish location and associated finish time, and a distance between the start location and finish location;
determining charging demand locations in the target area, being locations in which the target EVs need to charge, comprising performing a simulation of the routes taken by the target EVs based on the EV data, and plotting the charging demand locations onto a map of the target area;
retrieving population density data for the target area and plotting the population density data onto the map of the target area;
clustering, based on the map of the target area, the charging demand locations to determine candidate EV charging station locations; and
determining optimum EV charging station locations, comprising weighting the candidate EV charging station locations based on the population density data, and plotting the optimum EV charging station locations onto the map of the target area.

2. The computer-implemented method of claim 1, wherein the EV data further comprises, for each target EV, at least one of EV model, powertrain information, battery capacity, and range data.

3. The computer-implemented method of any preceding claim, wherein the EV data comprises the routes taken by the target EVs, or wherein the routes taken by the target EVs are determined based on the EV data.

4. The computer-implemented method of any preceding claim, wherein the simulation comprises an agent-based model configured to simulate the trips the target EVs took along their routes, based on the EV data, wherein the locations in which the target EVs needed to charge in the simulation are determined to be the charging demand locations.

5. The computer-implemented method of any preceding claim, wherein the plotting of the charging demand locations onto a map of the target area comprises plotting a heatmap of the charging demand locations

6. The computer-implemented method of any preceding claim, wherein the weighting comprises: the higher the population density at a particular candidate EV charging station location, the higher the weighting, and wherein the optimum EV charging station locations are selected from the candidate EV charging station locations which have relatively higher weightings.

7. The computer-implemented method of any preceding claim, wherein the clustering comprises determining a number of clusters of the charging demand locations, each cluster comprising a plurality of charging demand locations, and further comprising determining the centroid of each cluster.

8. The computer-implemented method of claim 7, wherein determining optimum EV charging station locations comprises weighting the candidate EV charging station locations based on the population density within a fixed radius of the centroid.

9. The computer-implemented method of claim 8, wherein determining optimum EV charging station locations comprises, for each centroid:
determining, for each charging demand location, the distance from the charging demand location to the centroid;
selecting a subset of the charging demand locations which are within the radius as the candidate EV charging station locations;
weighting and ranking the candidate EV charging station locations based on the population density at each candidate EV charging station location; and
selecting, from the candidate EV charging station locations, the optimum EV charging station locations as the plurality of candidate EV charging station locations with the highest ranking.

10. The computer-implemented method of claim 9, further comprising determining the number of slots at each optimum EV charging station location based on a relationship between the number of slots determined and the population density at the optimum EV charging station location.

11. The computer-implemented method of any preceding claim, wherein the clustering is performed using a machine learning model

12. The computer-implemented method of any preceding claim, wherein the real-world EV data is collected from sensors, such as GPS sensors, within each EV.

13. The computer-implemented method of any preceding claim, wherein the determined optimum EV charging station locations are used in a subsequent method to install real-world EV charging station locations at the determined optimum EV charging station locations.

14. An information processing apparatus comprising a memory and a processor connected to the memory, wherein the processor is configured to perform the method of automatically determining optimum electric vehicle (EV) charging station real-world locations, based on a simulation of a particular real-world target area in accordance with any of claims 1 to 13.

15. A computer program which, when run on a computer, causes the computer to carry out the method of automatically determining optimum electric vehicle (EV) charging station real-world locations, based on a simulation of a particular real-world target area in accordance with any of claims 1 to 13.

## Amended claims

### Amended claims in accordance with Rule 137(2) EPC.

1. A computer-implemented method (100) of automatically determining optimum electric vehicle (EV) charging station real-world locations, based on a simulation of a particular real-world target area, comprising:
receiving (S11) real-world EV data, comprising data for a plurality of target EVs associated with the target area, and for each target EV comprising at least one start location and associated start time, at least one finish location and associated finish time, a distance between the start location and finish location, and at least one of EV model, powertrain information, battery capacity, and range data;
determining (S13) charging demand locations (21) in the target area, being locations in which the target EVs need to charge, comprising performing a simulation of the routes taken by the target EVs based on the EV data, and plotting the charging demand locations onto a map of the target area;
retrieving (S15) population density data for the target area and plotting the population density data onto the map of the target area;
clustering (S17), based on the map of the target area, the charging demand locations to determine candidate EV charging station locations; and
determining (S19) optimum EV charging station locations, comprising weighting the candidate EV charging station locations based on the population density data, and plotting the optimum EV charging station locations onto the map of the target area.

2. The computer-implemented method of any preceding claim, wherein the EV data comprises the routes taken by the target EVs, or wherein the routes taken by the target EVs are determined based on the EV data.

3. The computer-implemented method of any preceding claim, wherein the simulation comprises an agent-based model configured to simulate the trips the target EVs took along their routes, based on the EV data, wherein the locations in which the target EVs needed to charge in the simulation are determined to be the charging demand locations.

4. The computer-implemented method of any preceding claim, wherein the plotting of the charging demand locations onto a map of the target area comprises plotting a heatmap of the charging demand locations

5. The computer-implemented method of any preceding claim, wherein the weighting comprises: the higher the population density at a particular candidate EV charging station location, the higher the weighting, and wherein the optimum EV charging station locations are selected from the candidate EV charging station locations which have relatively higher weightings.

6. The computer-implemented method of any preceding claim, wherein the clustering comprises determining a number of clusters of the charging demand locations, each cluster comprising a plurality of charging demand locations, and further comprising determining the centroid (41) of each cluster.

7. The computer-implemented method of claim 6, wherein determining optimum EV charging station locations comprises weighting the candidate EV charging station locations based on the population density within a fixed radius of the centroid.

8. The computer-implemented method of claim 7, wherein determining optimum EV charging station locations comprises, for each centroid:
determining, for each charging demand location, the distance from the charging demand location to the centroid;
selecting a subset of the charging demand locations which are within the radius as the candidate EV charging station locations;
weighting and ranking the candidate EV charging station locations based on the population density at each candidate EV charging station location; and
selecting, from the candidate EV charging station locations, the optimum EV charging station locations as the plurality of candidate EV charging station locations with the highest ranking.

9. The computer-implemented method of claim 8, further comprising determining the number of slots at each optimum EV charging station location based on a relationship between the number of slots determined and the population density at the optimum EV charging station location.

10. The computer-implemented method of any preceding claim, wherein the clustering is performed using a machine learning model

11. The computer-implemented method of any preceding claim, wherein the real-world EV data is collected from sensors, such as GPS sensors, within each EV.

12. The computer-implemented method of any preceding claim, wherein the determined optimum EV charging station locations are used in a subsequent method to install real-world EV charging station locations at the determined optimum EV charging station locations.

13. An information processing apparatus (10) comprising a memory (994) and a processor (993) connected to the memory, wherein the processor is configured to perform the method of automatically determining optimum electric vehicle (EV) charging station real-world locations, based on a simulation of a particular real-world target area in accordance with any of claims 1 to 12.

14. A computer program which, when run on a computer, causes the computer to carry out the method of automatically determining optimum electric vehicle (EV) charging station real-world locations, based on a simulation of a particular real-world target area in accordance with any of claims 1 to 12.
